(19) Europäisches Patentamt European Patent Office Office européen des brevets

(11) **EP 2 045 915 A1**

(12) **EUROPEAN PATENT APPLICATION**

(43) Date of publication:
08.04.2009 Bulletin 2009/15

(51) Int Cl.:
*H03F 3/45* (2006.01)  *H03F 3/189* (2006.01)
*H03G 1/00* (2006.01)

(21) Application number: 07117818.0

(22) Date of filing: 03.10.2007

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Seiko Epson Corporation**
**Shinjuku-ku,**
**Tokyo 163-0811 (JP)**

(72) Inventors:
• **GONZALEZ, Jose Luis**
**c/o Dep. d'Enginyeria Electr.**
**08034, Barcelona (ES)**
• **MATEO, Diego**
**c/o Universitat de Catalunya**
**08034, Barcelona (ES)**

• **ARAGONES, Xavier/2c/o Universitat de Catalunya**
**08034, Barcelona (ES)**
• **CAIRO MOLINS, Josep Ignasi**
**Epson Europe**
**08190, Sant Cugat del Vallés (Barcelona) (ES)**
• **GIL GALI, Ignacio**
**c/o Epson Europe Electronics**
**08190, Sant Cugat del Valles (Barcelona) (ES)**
• **TANAKA, Kazuaki**
**c/0 Epson Europe Electr.**
**08190, Sant Cugat del Vallés (Barcelona) (ES)**

(74) Representative: **Carpintero Lopez, Francisco et al**
**Herrero & Asociados, S.L.**
**Alcalá 35**
**28014 Madrid (ES)**

(54) **Low noise amplifier and mixer front-end circuit and method for gain control**

(57) The front end circuit comprises a LNA (1) coupled to an RF mixer (2), connected to at least one biasing resistor (R1, R2), and this circuit includes at least one transistor (6), preferably a MOSFET, connected in parallel to the biasing resistors (R1, R2) of the mixer (2), for adjusting the gain of the LNA (1) and compensating process variation effects. The transistor (6) is biased by a voltage which switches its operating point between linear region and off state in correspondence to at least two gain modes of the LNA (1). This biasing voltage can be an analog signal to tune control of the gain level operating the LNA (1) in a gain mode as a VGA.

The invention also relates to an RF transmitter and/or receiver including the low noise amplifier and mixer front end, and to a method for gain control of said low noise amplifier.

FIG. 1

Printed by Jouve, 75001 PARIS (FR)

**Description**

FIELD OF THE INVENTION

The invention relates generally to the field of wireless communications, especially to the operation of Radio Frequency (RF) transceivers. More particularly, the present invention refers to a circuit and a method for controlling a low noise amplifier (LNA) gain modes.

STATE OF THE ART

Within the field of radio communication, such as satellite communication or mobile communication, there is an increasing need of low power amplifier stages. For safe information signal recovery, low noise amplifiers (LNAs) are used in this field.

As described in papers, product application notes, and textbooks, there are currently several approaches to the design of a radio frequency (RF) receiver front end, which commonly includes a low-noise amplifier (LNA) followed at its output by a mixer and, at the input of the LNA, an antenna that receives the incoming electromagnetic field and, after a filter stage, provides a single-ended RF input signal. The LNA receives the weak RF input signal from the antenna and amplifies the signal while adding as little noise as possible. The mixer then converts its input signal from its RF frequency to a lower intermediate frequency for further processing by the receiver baseband. In order to produce this intermediate frequency (IF) signal, the mixer subtracts the RF input at the RF frequency from a signal produced by a local oscillator (LO).

When designing the RF receiver front end, the relevant factors include noise figure, linearity, voltage gain, and power consumption.

For power consumption reduction, the LNA is preferred to operate with a lower gain, whenever the signal level from the antenna does not need to be amplified with a high gain. That is, a 2-mode gain LNA is desirable. In any of the wireless communications standards, typical requirements for LNAs providing two diferenciated gain modes or states are:

- High gain mode having about 10 - 20 dB power gain
- Low gain mode showing about -10dB gain.
- Input and output port matched to system impedance in both gain modes.
- Zero power consumption in low gain mode.

The high gain of 10 to 20 dB is typically required to fulfill the receiver sensitivity requirements. A low gain of approximately -10dB is often desirable since this allows the LNA to operate in a passive mode at zero power consumption in the low gain state and still provide adequate isolation between the preceding an succeeding passive filters. Operation in low gain mode is usually applied only in cases where the LNA is provided with very high signal level inputs within the signal level working range (therefore, an attenuation function is required).

Within an RF transceiver, the receiver chain has then to comply a design requirement of being able to work in at least two different gain modes, depending on the amplitude of the RF signal detected by the antenna. The gain mode switch or change can be performed either in the LNA or in the mixer of the RF receiver Front End. Since the LNA is the block that provides the main voltage gain of the complete chain, an inmediate option is to introduce the switchable gain capability in the LNA design. But special care must be taken in order to keep the same LNA structure and not to alter its Scattering or S-parameters, the resulting gain and noise figure.

The voltage gain of the LNA is determined by the real part of its load impedance, which is in turn, when connected to the mixer, set basically by the mixer input impedance (also it has some dependence on the output resistance of the LNA and parasitic resistance of passive elements such as inductor load, etc). This impedance is dominated by the biasing or blocking resistor connected at the mixer RF inputs. Therefore, adjusting the resistive part of the mixer input (i.e., the resistance value of the biasing resistor of the mixer), the gain of the LNA can be changed, without altering the LNA structure and basic performance; however, it can affect the mixer structure.

In order to affect neither the LNA nor the Mixer and prevent the altering of their operation and performance according to the desing specifications, it is convenient to make switchable the biasing resistor of the mixer RF input. In fact, the real part of the mixer input impedance is basically dominated by the value of these resistors. A possible solution is to change that effective resistor value by adding just an extra resistor in parallel with the biasing structure (original resistors of the mixer). Nonetheless, the problem of such implementation is that the structure needs to be complemented with a switchable device responsible for the connection and disconnection of said additional resistor. Besides, the required switchable device must be governed by a digital control voltage, which is adjusted according to the amplitude level of the received RF signal. The gain adjustment by digital voltage restringes each gain mode to a fixed gain level, limiting the number of operating gain modes (up to four levels) in conventional gain switchable low noise amplifiers.

DESCRIPTION OF THE INVENTION

An object of the present invention is to provide a low noise amplifier (LNA) with multiple (at least two) selectable gain modes having an improved efficiency and enhanced quality of the output signal in any of the gain states available. Another object of the present invention is to achieve the aforesaid object at a minimised amount of energy consumption reached by an RF front-end circuit having a reduced number of elements and size. An even further object of the present invention is to allow adjustment of the gain without altering the structure of either the LNA either the RF mixer and without affecting the basic performance of the RF circuit.

One aspect of the invention relates to a gain control circuit designed to be connected between the output of a low noise amplifier and the input of a mixer in an RF transmitter/receiver front-end. The proposed gain control circuit modifies matching network (e.g., a typical "L" section, a Pi network, etc.) between the low noise amplifier and the mixer, which is required to adapt the respective impedances (typically to 50 Ohms) at the output of the LNA and the input of the mixer, in order to maximize the power transfer and minimize reflections from the load.

In the Radio Frequency (RF) transceiver front-end, the RF signal interfaces a single-ended or two-ended low noise amplifier (LNA) and goes once amplified into a mixer coupled to the output of the LNA. The gain of the LNA is adjusted to maximize signal-to-noise ratio of the mixer and to force the mixer to operate well within its linear region when an intermodulation interference component is present. In order to improve the signal-to-noise ratio of an RF signal presented to the mixer by the LNA, the gain of the LNA is adjusted. In adjusting the gain of the LNA, great care must be taken. While maximizing the gain of the LNA serves to increase the Signal to Noise Ratio (SNR) of the RF signal, if the LNA gain is too large, the mixer will be driven into non-linear operation and the intermediate frequency (IF) signal produced by the mixer will be distorted. Thus, it is desirable to have the LNA working in a high gain mode wherein it provides as great an amplification of the received RF signal as possible prior to presenting the amplified RF signals to the mixer without driving the mixer into non-linear operation. But also it is desirable to allow the LNA to work in a low gain mode when a high amplification is not needed in order to reduce power consumption. Therefore, at least 2-mode gain selectable LNA is desirable.

The technique proposed here consists in inserting in the LNA and mixer front-end circuit at least a switching element that has a linear regimen of operation wherein said switching element is equivalent to a resistor. Complying with this condition, at least one transistor acting as a switchable resistor is connected in parallel to the biasing resistors of the mixer, constituting the network or circuit for biasing the mixer as well as for gain control of the LNA. Such transistor or switching element can be selected from the type of bipolar transistors: a PNP or NPN bipolar junction transistor (BJT) and, preferably a heterojunction bipolar transistor (HBT) can be used. Another preferred selection is using a MOSFET transistor, which may be either a p-channel (PMOS) or n-channel (NMOS) MOSFET, inserted in parallel to the biasing resistors of the mixer.

Since this point of the circuit (the blocking resistors of the RF input signal) corresponds to the biasing of a transistor gate (a MOSFET of the mixer), there is no current flowing through the biasing resistors and, consequently, both the drain and source of the MOSFET transistor (correspondingly, the emitter and collector regions of the bipolar transistor) added for gain control are biased at the same voltage. As a result, said additional transistor does not consume DC current and it can act as a bypass switch by simply change its DC operating point between the linear region an the off state.

This transistor, when biased in the linear region by a gate voltage signal that may be digital or analog, is equivalent to a resistor which, in case of using MOSFET, is controllable by the gate voltage relative to both the source and drain voltages of said MOSFET. In linear region, the transistor is turned on and a channel has been created which allows current to flow between the drain and source. The current from drain to source ($I_{DS}$) of a MOSFET in the linear region is modelled as:

$$I_{DS} = \mu_n C_{ox} \frac{W}{L} \left[ (V_{GS} - V_{th}) V_{DS} - \frac{V_{DS}^2}{2} \right] \qquad \text{(equation 1)}$$

being the charge-carrier effective mobility ($\mu_n$) and the gate oxide capacitance per unit area ($C_{OX}$) known parameters of the transistor, and where design parameters of this transistor are the gate width (W) and the gate length (L). $V_{GS}$ is the gate voltage and $V_{DS}$ is the drain voltage both relative to the source voltage, and $V_{th}$ is the threshold voltage of the transistor that makes it turn off interrupting conduction between drain and source.

For a n-channel MOSFET (NMOS), the linear region is when $V_{GS} > V_{th} > 0$ and $V_{DS} < (V_{GS} - V_{th})$, being $V_{DSsat} = V_{GS} - V_{th}$, the saturation drain voltage for which the MOSFET is turned on and, since the drain voltage is higher than the gate voltage, a portion of the channel created is turned off and the rest allows current to flow, relatively independent of the drain voltage, between the drain and source. On the contrary, a p-channel MOSFET (PMOS) enters the linear region when $V_{GS}<V_{TH}<0$ and $0>V_{DS}>V_{DSsat}$.

Hence, for both types of MOSFET, from equation 1 it follows:

$$\frac{\partial I_{DS}}{\partial V_{DS}} = K_n \frac{W}{L}\left[\left(V_{GS}-V_{TH}\right)-V_{DS}\right], \quad \text{being} \quad K_n = \mu_n \; C_{ox}, \quad \text{and}$$

$$g_{ds} = \frac{\partial I_{DS}}{\partial V_{DS}}\bigg|_{VDS=0} = K_n \frac{W}{L}\left(V_{GS}-V_{TH}\right).$$

The MOSFET operates like a resistor with a determined resistance value ($r_o$), which can be dependent on the transistor gate width (W) and on the gate voltage ($V_{GS}$), given by the following equation:

$$r_o = \frac{1}{g_{ds}} = \frac{1}{K_n \dfrac{W}{L}\left(V_{GS}-V_{TH}\right)}$$

Therefore, in the linear region of operation, the MOSFET transistor added in parallel to the biasing resistors of the mixer can be used to integrate in a single device (itself) the mode switching process and the resistance value needed to determine the proper gain provided by the LNA for each case. As a result, there is no need to add any additional resistor and the voltage gain commutation process can be easily adjusted with the MOSFET gate width and its biasing voltage.

It is still an option in the design process to ease the adjustment of the resistance value inserting an extra resistor in series to the MOSFET.

Using n values for the gate voltage of this MOSFET, a LNA with selectable n-gain modes is achieved. The most usual case regards to 2-gain levels: low-gain mode (LGM) and high-gain mode (HGM). The LGM is obtained by biasing the MOSFET in its linear region (VG=0 if a PMOS is used, VG>0 in NMOS), so as to make it equivalent to a resistor and reduce the resulting equivalent resistance of the mixer RF input, with the result of the increasing of the LNA mismatching. The suitable resistance value is fixed by properly adjusting the gate width of the transistors, that is, the number of fingers and the width/finger. Concerning the HGM, the device is cut-off (VG=0 if a NMOS is used, VG>0 in PMOS) by increasing its gate biasing voltage. As a result, the MOSFET acts as an open circuit and does not contribute any resistance value in parallel to the original blocking resistors of the mixer (the real part of the loading impedance of the LNA is not modified). Therefore, the original gain value of the LNA is preserved (optimum matching case).

This technique can also be extended by using an analog gate voltage, instead of a two valued gate voltage, to have a tune control of the gain of the LNA in the high gain mode, which can be used to implement a variable gain amplifier (VGA) or to compensate for process variations on the gain of the LNA + Mixer front end.

A similar behaviour is expected if a BJT or HBT transistor takes the place of the MOSFET as explained, considering in this context that the gate of a MOSFET is equivalent to the base of a bipolar transistor, as well as the drain and the source of the MOSFET correspond to the collector and the emitter respectively of the bipolar transistor.

The present invention comprises the implementation of this technique for both applications: changing the gain of the LNA and compensating process variations effects.

Another aspect of the invention relates to a method for gain control in a low noise amplifier and mixer front end circuit which comprises the steps of:

- connecting at least one transistor, either a PMOS or an NMOS either a PNP or NPN bipolar transistor, in parallel to the biasing resistor of the RF mixer,
- biasing the transistor by a, digital or analog, biasing voltage that determines one of at least two gain modes and sets a gain level of the LNA,
- switching the gain mode of said LNA by changing the biasing voltage of said transistor to commute between linear region and cut-off state.

When using a MOSFET transistor and having said MOSFET transistor biased in the linear region, the step of setting the gain level of the LNA further comprising determining a gate width of the MOSFET transistor that corresponds to the equivalent resistance value ($r_o$) of said MOSFET in the linear region that sets the gain level of the LNA.

Another aspect of the invention relates to an RF transmitting and/or receiving unit that contains a low noise amplifier and mixer front end circuit implementing the described method.

BRIEF DESCRIPTION OF THE DRAWINGS

To complete the description and in order to provide for a better understanding of the invention, a set of drawings is provided. Said drawings form an integral part of the description and illustrate preferred embodiments of the invention, which should not be interpreted as restricting the scope of the invention, but just as examples of how the invention can be embodied. The drawings comprise the following figures:

Figures 1 shows a schematic representation of an RF receiver front-end in accordance with a possible embodiment of the invention.
Figure 2 shows a graphical representation of S-parameter measurements obtained by simulation in the RF front-end of Figure 1 operating for two gain modes.
Figure 3 shows a graphical representation of voltage gains obtained by simulation in the RF front-end of Figure 1 operating for two gain modes.
Figure 4 shows a graphical representation of noise figure measurements obtained by simulation in the RF front-end of Figure 1 operating for two gain modes.

DESCRIPTION OF A PREFERRED EMBODIMENT OF THE INVENTION

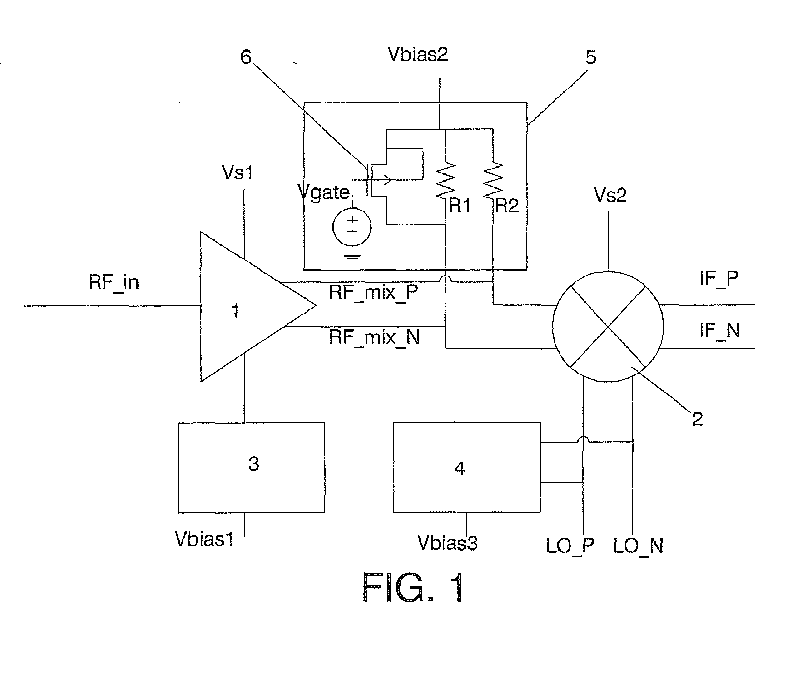

An RF receiver front-end constructed according to one possible embodiment of the present invention, as illustrated in Figure 1, comprises a low noise amplifier or LNA (1), coupled to an antenna and filter that are not represented in this Figure, which adjusts with gain a received RF input signal (RF_in). In this example, the LNA (1) presents a single-ended input and double-ended output and is biased by a first biasing voltage ($V_{bias1}$) generated by a LNA biasing network (3). Coupled to the output of said LNA (1), at which amplified RF differential signals (RF_mix_P, RF_mix_N) are delivered, the RF front-end includes an RF mixer (2) with a corresponding mixer biasing network (5) that supplies the mixer transistors by means of a second biasing voltage ($V_{bias2}$). The mixer biasing network (5) comprises a series of biasing resistors, represented in Figure 1 as biasing resistors (R1, R2) which may be composed of a plurality of resistors connected in series. Additionally, the LNA (1) and the RF mixer (2) are supplied directly by respective DC supply voltages (Vs1, Vs2). The RF mixer (2) mixes the level adjusted signals (RF_mix_P, RF_mix_N) aforementioned at the output of the LNA (1) with input signals (LO_P, LO_N) from a Local Oscillator or LO, not shown in the Figure 1, which in turn has its LO biasing network (4) providing a third biasing voltage ($V_{bias3}$) for this LO. At the output of the RF mixer (2) a wideband signal about an Intermediate Frequency or IF differential signals (IP_P, IF_N) are produced. In Figure 1, the references P and N of the signals denotes the positive and negative branches of the corresponding differential signal.

In order to select the operation mode of the LNA (1) and adjust the gain level that determines each operation mode, a transistor (6), which is a PMOS in the example illustrated in Figure 1, is connected in parallel to the biasing resistors (R1, R2) in the mixer biasing network (5), so that said mixer biasing network (5) can become a gain-mode control circuit for the LNA (1).

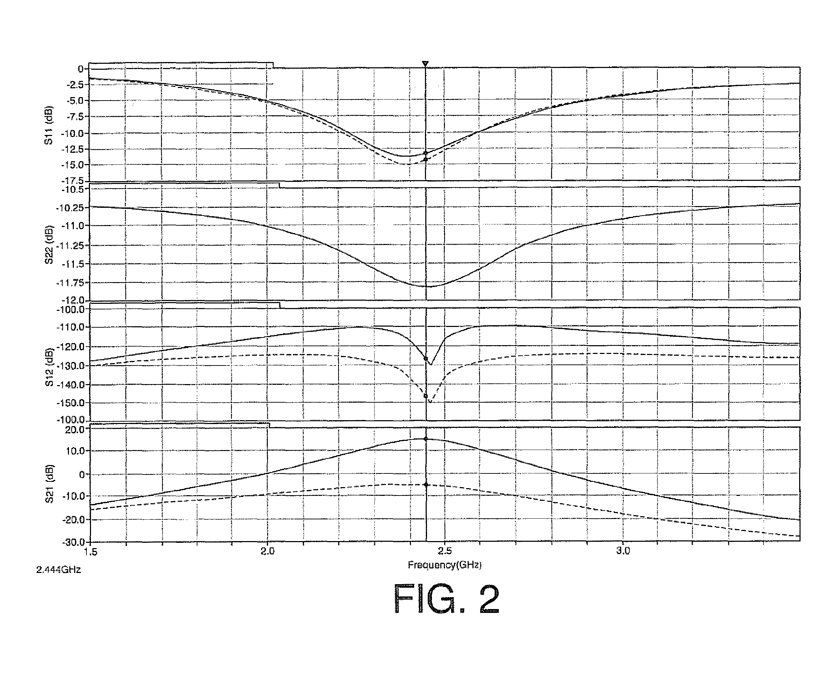

Some simulations on the LNA+Mixer front-end illustrated in Figure 1 complemented with this gain-mode control circuit have been performed and the results are shown in the different graphics of Figures 2-4. The graphics drawn in dots correspond to simulation measurements having adjusted a low gain mode, while the continuous curves correspond to high gain mode. The gain-mode control circuit has the PMOS acting as a variable resistor in parallel with the biasing resistors (R1, R2) when said PMOS is biased in its linear region, i.e, the gate voltage ($V_{gate}$) equals to cero: $V_{gate} = 0$ and this defines a low gain mode because the equivalent resistance at the mixer input is decreased and thus the LNA load is modified. This fact implies a variation of the optimum matching condition. When the gate voltage ($V_{gate}$) is increased until the PMOS is cut-off, for example, being $V_{gate} = 1.2$ V, the PMOS is not adding resistance to the original biasing resistors (R1, R2) of the mixer (2) and so the original gain value of the LNA (1) is applied in a high gain mode. The design of the gain-mode control circuit has been focused on obtaining 50Ω input impedance, including ESD protection diodes in the LNA (1), which has an original gain value of about 29 dB, while keeping DC consumption within specifications for a low gain value of about 8 dB. The LNA (1) works for an RF input signal (RF_in) on the 2.45 Ghz band, for example for Bluetooth applications; the circuit works for other RF applications in the frequency range of 1-10 GHz, though. A PMOS with a gate width (W) of 12 $\mu$m, W = (24 fingers x 0.5 $\mu$m /finger) is used.

Figure 2 shows four rows of curves representing the S-parameters measured for both gain modes: the curves drawn by a solid line correspond to the high gain mode whilst the dotted curves correspond to the low gain mode. From up to bottom, in Figure 2, the four rows of curves illustrated respectively: the input port voltage reflection coefficient ($S_{11}$), the isolation coefficient ($S_{12}$), the forward voltage gain ($S_{21}$) and the output port voltage reflection coefficient ($S_{22}$). No significant changes are observed in the S-Parameters of the LNA+Mixer front-end complemented with the gain-mode control circuit with respect to the LNA+Mixer front-end without PMOS; only the $S_{21}$ value is reduced considerably in the low gain mode as a result of the reduction on the LNA voltage gain.

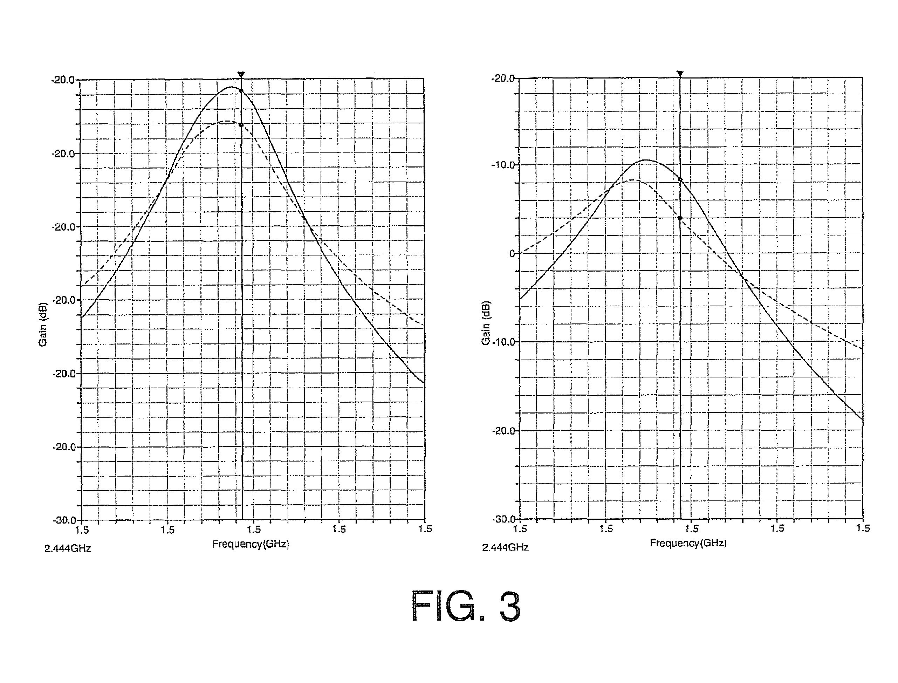

Figure 3 shows a left set of curves that indicate the voltage gains measured at different points of the circuit, the LNA voltage gain (Gv_LNA) drawn in dots and the LNA+Mixer voltage gain (Gv_LNA&Mix) drawn by a solid line, working in the high gain mode; the right set of curves illustrates the same voltage gains but in the low gain mode of operation. Only the LNA voltage gain (Gv_LNA) becomes altered by the gain control circuit. The resulting LNA+Mixer voltage gains (Gv_LNA&Mix) are approximately 28.3dB for the high gain mode and 8.4dBV for the low gain mode.

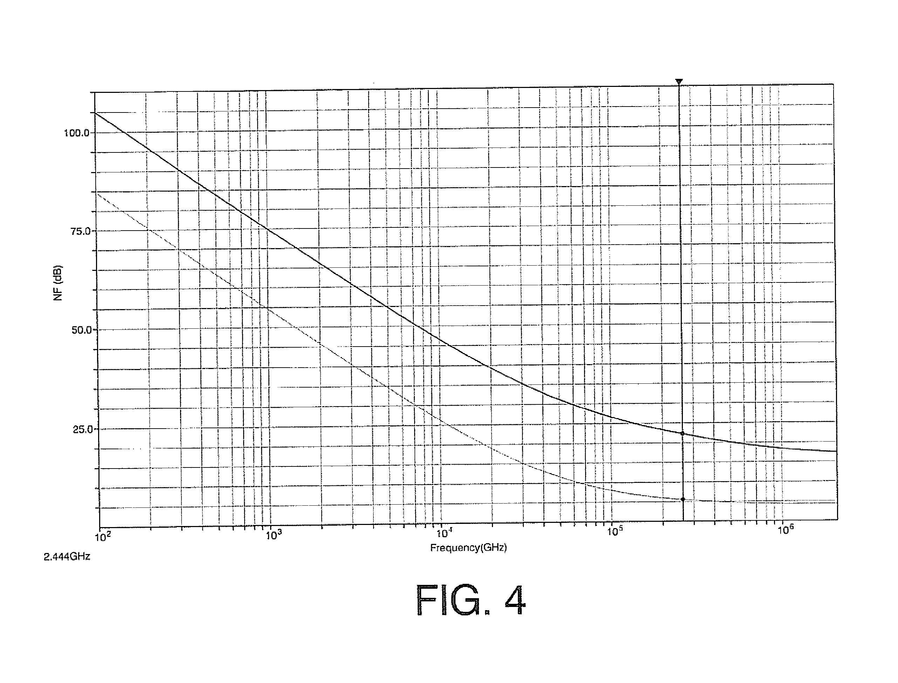

This affects directly the Noise Figure (NF) of the circuit, as it can be seen in Figure 4, where the upper curve is the variation of the Noise Figure (NF) in the low gain mode and the lower one corresponds to the high gain mode. The behaviour of the noise figure is the expected with the result of a increasing of the noise figure for lower gain values. Moreover, the linearity of the RF signal chain is also affected, leading to a more linear response in the low gain mode.

In the context of the present invention, the term "approximately" should be understood as indicating values very near to those which accompany the aforementioned term and the same applies to the terms "about" and "around". That is to say, a deviation within reasonable limits from an exact value should be accepted, because a skilled person in the art will understand that such a deviation from the values indicated is inevitable due to measurement inaccuracies, etc.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

Some preferred embodiments of the invention are described in the dependent claims which are included next.

**Claims**

1. Low noise amplifier and mixer front end circuit for gain control comprising a LNA (1) coupled to a mixer (2) that is connected to at least one biasing resistor (R1, R2), **characterised by** further comprising at least one transistor (6) connected in parallel to the, at least one, biasing resistor (R1, R2) of the mixer (2), having the transistor (6) a gate, or a base, biased by a voltage which switches said transistor (6) operating point between linear region and off state in correspondence to at least two gain modes of the LNA (1).

2. Low noise amplifier and mixer front end circuit according to claim 1, wherein the at least one transistor (6) is a bipolar transistor, having a base biased by a voltage which switches said transistor (6) operating point between linear region and off state in correspondence to at least two gain modes of the LNA (1).

3. Low noise amplifier and mixer front end circuit according to claim 1, wherein the at least one transistor (6) is a MOSFET, having a gate biased by a voltage which switches said transistor (6) operating point between linear region and off state in correspondence to at least two gain modes of the LNA (1),

4. Low noise amplifier and mixer front end circuit according to claim 3, wherein the at least one transistor (6) is a PMOS.

5. Low noise amplifier and mixer front end circuit according to claim 3, wherein the at least one transistor (6) is a NMOS.

6. Low noise amplifier and mixer front end circuit according to any of the claims 3-5, wherein the at least one transistor (6) has a gate width that determines an equivalent resistance value of said at least one transistor (6) operating in the linear region.

7. Low noise amplifier and mixer front end circuit according to claim 2, wherein the at least one transistor (6) has a base width that determines an equivalent resistance value of said at least one transistor (6) operating in the linear region.

8. Low noise amplifier and mixer front end circuit according to any of the preceding claims, further comprising at least one extra resistor connectable in series to the, at least one, transistor (6).

9.  A radiofrequency transmitting and/or receiving unit comprising a low noise amplifier and mixer front end circuit according to at least one of the proceeding claims.

10. A radiofrequency transmitting and/or receiving unit according to claim 9, **characterized in that** it makes part of a mobile user equipment such as a mobile telephone or a Bluetooth device.

11. Method for gain control in a low noise amplifier and mixer front end circuit which includes a LNA (1) coupled to an RF mixer (2) connected to at least one biasing resistor (R1, R2), comprising the steps of:

    - connecting at least one transistor (6) in parallel to the, at least one, biasing resistor (R1, R2) of the RF mixer (2);
    - biasing the transistor by a biasing voltage which determines one of at least two gain modes and sets a gain level of the LNA (1);
    - switching the gain mode of said LNA (1) by changing the biasing voltage of said transistor (6) to commute between linear region and off state.

12. Method according to claim 11, wherein said biasing voltage of the, at least one, transistor (6) is a digital signal.

13. Method according to claim 11, wherein said biasing voltage of the, at least one, transistor (6) is an analog signal.

14. Method according to any of claims 11-13, wherein, biased the transistor (6) in the linear region, the step of setting the gain level of the LNA (1) further comprising determining a gate width if a MOSFET is used, or a base width if a bipolar transistor is used, for said transistor (6) by calculating an equivalent resistance value of said MOSFET transistor (6) in the linear region.

15. Method according to claim 14, further comprising the step of adding a certain resistance value to the equivalent resistance value of the transistor (6), for setting the gain level of the LNA (1), by connecting an extra resistor in series to said transistor (6).

FIG. 1

EP 2 045 915 A1

EP 2 045 915 A1

FIG. 2

2.444GHz

FIG. 3

FIG. 4

**European Patent Office**

**EUROPEAN SEARCH REPORT**

Application Number

EP 07 11 7818

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/281430 A1 (YAMAMOTO MASAKI [JP]) 14 December 2006 (2006-12-14) * paragraphs [0002], [0012] - [0027], [0036], [0042] - [0046], [0049] - [0051], [0055] - [0057], [0059] - [0062]; figures 1,2,4-6 * | 1-15 | INV. H03F3/45 H03F3/189 H03G1/00 |
| X | US 5 675 290 A (TSUKAHARA YOSHIHIRO [JP] ET AL) 7 October 1997 (1997-10-07) * column 2, lines 10-23,33-43; figures 4,5 * * column 5, line 54 - column 7, line 6 * | 1-15 | |
| A | EP 0 818 879 A (FUJITSU LTD [JP]) 14 January 1998 (1998-01-14) * column 18, line 57 - column 20, line 33; figure 12 * | 1-15 | |

TECHNICAL FIELDS SEARCHED (IPC)

H03D
H03G
H03F

The present search report has been drawn up for all claims

| Place of search | Date of completion of the search | Examiner |
|---|---|---|
| The Hague | 14 April 2008 | Goethals, Filip |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 11 7818

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2008

| Patent document cited in search report | | Publication date | Patent family member(s) | | Publication date |
|---|---|---|---|---|---|
| US 2006281430 | A1 | 14-12-2006 | NONE | | |
| US 5675290 | A | 07-10-1997 | JP | 9051238 A | 18-02-1997 |
| EP 0818879 | A | 14-01-1998 | CN | 1170988 A | 21-01-1998 |
| | | | DE | 69726058 D1 | 18-12-2003 |
| | | | DE | 69726058 T2 | 26-08-2004 |
| | | | JP | 3508401 B2 | 22-03-2004 |
| | | | JP | 10028020 A | 27-01-1998 |
| | | | US | 5994963 A | 30-11-1999 |

EPO FORM P0459

For more details about this annex : see Official Journal of the European Patent Office, No. 12/82